# EUROPÄISCHE PATENTANMELDUNG

(11) **EP 0 722 207 A1**
(43) Veröffentlichungstag der Anmeldung: **17.07.1996**
(21) Anmeldenummer: 96100037.9
(22) Anmeldetag: 03.01.1996
(51) Int. Cl.: H01S 3/025

(54) **Integriert-optische Anordnung aus Halbleiterlaser und Monitordetektor**

(30) Priorität: 13.01.1995 DE 19501251
(71) Anmelder: SIEMENS AKTIENGESELLSCHAFT, 80333 München (DE)
(72) Erfinder: Matz, Richard, Dr., D-83052 Bruckmühl (DE)

(57) **Zusammenfassung**

Um bei einer integriert-optischen Anordnung aus Halbleiterlaser (2) und Monitordetektor (3) die Rückwirkung der Reflexion der Laserstrahlung am Detektor zu unterdrücken und zugleich die Brechung der Strahlung am Detektor zu berücksichtigen und kompensieren, sind die einander gegenüberliegenden Stirnflächen (22, 31) des Lasers und Detektors beide im wesentlichen senkrecht zur Oberfläche (10) des Substrats (1), aber schräg im Winkel (α) zueinander angeordnet. Anwendung: Lasermodule der optischen Nachrichtentechnik, insbesondere bidirektionale Chips.

## Beschreibung

Die Erfindung betrifft eine integriert-optische Anordnung aus Halbleiterlaser und Monitordiode nach dem Oberbegriff des Patentanspruchs 1.

In Modulen der optischen Nachrichtentechnik werden Halbleiterlaser verschiedenster Bauart und Emissionswellenlänge als Lichtquellen verwendet, um elektrische Datensignale in optische umzuwandeln und über eine optische Glasfaser zu übertragen. Durch innere und äußere Einflüsse wie Alterung und Temperaturdrift kann sich die emittierte Leistung eines Halbleiterlasers bei festem Laserstrom verändern. Um das Leistungsbudget auf der Strecke nicht zu beeinträchtigen, muß deshalb mit Hilfe eines im Sendemodul eingebauten optischen Monitordetektors, beispielsweise eine Monitordiode, die optische Laserleistung durch Regelung des Laserstroms konstant gehalten werden. Monitordetektoren werden heute in der Regel als individuelle diskrete Bauelemente in relativ teuerer mikrooptischer Aufbautechnik eingesetzt (siehe Werbeschrift "BIDI Bidirektionale Module" der Siemens AG, Berlin und München, Nr. B155-H6656-X-X-7400 (1993)).

Seit einigen Jahren wird deshalb als Alternative auch die monolithische Integration des Monitordetektors mit dem Halbleiterlaser untersucht, siehe dazu beispielsweise:
a) K.Dütting, W. Idler, J.Bouayad-Amine, H.P.Mayer und K.Wünstel "Realization and Wafer Test of InGaAsP/InP DFB Laser/Monitor OEICs", IEEE Phot. Technol. Lett. 4, S. 250-252 (1992);
b) J.Yoshida, Y.Yamada, M. Kobayashi und N.Tsuzuki "Optoelectronic and Photonic Integrated Devices for Optical Modules in Fiber Optic Subscriber Systems", SUPERCOMM/ICC 1992, Chicago 14.-18. Juni 1992, S. 1784-1788, Vol. 4, 1992, New York, USA;
c) K.Dütting, W.Idler und P.Wiedermann "10 Gbit/s DFB Laser/Monitor PICs for Low Cost High Speed Laser Modules", Electronics Lett. 29, S. 2145-2146 (1993);
d) M.A.Rothman, C.L.Shieh, A.J.Negri, J.A.Thompson, C.A. Armiento, R.P. Holmstrom und J.Knaur "Monolithically Integrated Laser/Rear-Facet Monitor Arrays with V-Groove for Passive Optical Fiber Alignment" IEEE Phot. Technol. Lett. 5, S. 169-171 (1993);
e) R.Matz, J.G.Bauer, P.Clemens, G.Heise, H.F.Mahlein, W.Metzger, H.Michel und G.Schulte-Roth "Development of a photonic integrated transceiver for WDM transmisison", Tagungsband der Postdeadline Beiträge zur Integrated Photonics Research Konferenz, San Francisco, 17.-19.2.1994 und/oder
f) N.Bouadma und J.Semo "1..3-µm GaInAsP/InP Buried Redge Structure Laser and its Monolithic Integration with Photodetector Using Reactive Ion Beam Etching", J. Lightwave Technol. 12, S. 742-748 (1994).

Hierdurch wird eine zweifache Kostenersparnis beim Modul erwartet: Zusammen mit Messungen des elektrischen Rauschens (siehe P.A.Andrekson, P.Andrekson, A.Alping, und S.T.Eng "Wide-Band Electrical Noise Measurements for In-Situ Optical Characterisation of Laser Diodes", Proc. IOOC-ECOC 1985, S. 733-736 und W. Idler, H. Schweizer, R.J.Lang, M.Klenk und A.Mozer "Advanced Noise Investigations in InGaAs/InP DFB Lasers", Proc. ECOC 1988, S. 380-383) gestattet der integrierte Monitordetektor eine weitgehende Charakterisierung der Halbleiterlaser schon auf dem Wafer. Außerdem entfallen bei monolithisch integrierten Anordnungen aus Halbleiterlaser und Monitordiode die Kosten für Herstellung, Einbau und Justage eines diskreten Monitordetektors im Modul. Integrierte Monitordetektoren bestehen in der Regel aus Monitordioden in Form einer rückseitigen Fortsetzung eines Steges des auf einer Oberfläche eines Substrats integrierten Halbleiterlasers. Diese Detektoren weisen damit die gleiche Bauelementstruktur wie der Halbleiterlaser auf, werden aber mit umgekehrter elektrischer Polung betrieben. Deshalb sind sie durch einen mehrere Mikrometer tiefen Trenngraben vom Halbleiterlaser elektrisch zu isolieren. Die einander gegenüberliegenden Seitenwände dieses Trenngrabens definieren eine Laserstrahlung emittierende Stirnfläche des Halbleiterlasers und eine zum Empfang dieser Laserstrahlung dienende Stirnfläche des Monitordetektors, die sich in einem Abstand voneinander gegenüberliegen.

Die Effizienz oder Responsivität des Monitordetektors, gemessen in mA Photostrom pro mW Laserleistung, hängt davon ab, wieviel Laserlicht durch den Trenngraben noch in den Monitordetektor eingekoppelt werden kann. Hierbei besteht ein Trade-Off bzw. Kompromiß zwischen Koppelwirkungsgrad und unerwünschter Rückreflexion in den Halbleiterlaser, die diesen instabil macht.

Aus den obengenannten Literaturstellen a) und f) ist jeweils eine Anordnung der eingangs genannten Art bekannt, bei der von den einander gegenüberliegenden Stirnflächen des Halbleiterlasers und des Monitordetektors die Stirnfläche des Halbleiterlasers senkrecht und die Stirnfläche des Monitordetektors derart schräg im Winkel zur Oberfläche des Substrats steht, daß der an der schrägen Stirnfläche des Monitordetektors reflektierte Anteil der aus der Stirnfläche des Halbleiterlasers emittierten Laserstrahlung die Stirnfläche des Monitordetektors nach oben von der Oberfläche des Substrats fort verläßt und nicht mehr in den Halbleiterlaser gelangt.

Der in den Monitordetektor eintretende Anteil der im wesentlichen senkrecht von der Stirnfläche des Halbleiterlasers emittierten Laserstrahlung wird an der schrägen Stirnfläche des Monitordetektors gebrochen, wodurch die Anregung von im Monitordetektor geführten optischen Moden schlechter gelingt und die Responsivität des Monitordetektors vermindert ist. Für eine Fabry-Perot-Struktur erhielten Bouadma et al (obige Literaturstelle f)) eine Responsivität von 0,05 A/W und für eine DFB-Struktur (DFB steht für distributed feedback = verteilte Rückkopplung) Dütting et al (obige Literaturstelle a)) eine Responsivität von 0,0025 A/W.

Aus den obigen Literaturstellen b)und d) ist jeweils eine integriert optische Anordnung bekannt, bestehend aus einem Halbleiterlaser und einem optischen Monitordetektor, die auf der Oberfläche eines gemeinsamen Substrats derart integriert sind, daß eine Laserstrahlung emittierende Stirnfläche des Halbleiterlasers und eine zum Empfang dieser Laserstrahlung dienende Stirnfläche des Monitordetektors einander parallel und in einem Abstand voneinander gegenüberliegen und senkrecht zur Oberfläche des Substrats stehen. Die Einkopplung der im wesentlichen senkrecht aus der Stirnfläche des Halbleiterlasers austretenden Laserstrahlung in den Monitordetektor durch dessen Stirnfläche ist relativ gut und führt zu hoher Responsivität des Monitordetektors. Mit einer Fabry-Perot-Struktur erreichten Yoshida et al (obige Literaturstelle b)) eine Responsivität von 0,1 A/W und Rothmann et al (obige Literaturstelle d)) bei einem Abstand von 5 µm zwischen der Stirnfläche des Halbleiterlasers und der gegenüberliegenden Stirnfläche des Monitordetektors eine Responsivität von 0,4 A/W. Nichtlineare Kennlinien deuten im letztgenannten Fall jedoch auf eine Rückwirkung der Stirnfläche des Monitordetektors auf den Halbleiterlaser hin.

Auch integriert-optische Anordnungen aus Halbleiterlaser und Monitordetektor mit DFB-Struktur neigen zu instabilem Verhalten (siehe obige Literaturstelle e)) . Bei einem Abstand von 3 µm zwischen der Stirnfläche des Halbleiterlasers und der gegenüberliegenden Stirnfläche des Monitordetektors wurde bei einer solchen Anordnung eine Responsivität von 0,1 A/W erhalten.

Wegen einer großen Strahldivergenz im Bereich zwischen der Stirnfläche des Halbleiterlasers und der gegenüberliegenden Stirnfläche des Monitordetektors läßt sich die Rückwirkung des Monitordetektors auf den Halbleiterlaser durch einen größeren Abstand zwischen diesen Stirnflächen unterdrücken. Allerdings nimmt dann auch die in den Monitordetektor eingekoppelte optische Leistung ab, was eine geringere Responsivität bedeutet, beispielsweise nach der obigen Literaturstelle c), eine Responsivität von 0,04 A/W.

Aufgabe der Erfindung ist es, aufzuzeigen, wie bei einer integriert-optischen Anordnung, bestehend aus einem Halbleiterlaser und einem optischen Monitordetektor, die auf der Oberfläche eines gemeinsamen Substrats derart integriert sind, daß eine Laserstrahlung emittierende Stirnfläche des Halbleiterlasers und eine zum Empfang dieser Laserstrahlung dienende Stirnfläche des Monitordetektors einander gegenüberliegen und in einem Abstand voneinander angeordnet sind, die Rückwirkung der Reflexion der Laserstrahlung an der Stirnfläche des Monitordetektors unterdrückt und zugleich die Brechung der Laserstrahlung an dieser Stirnfläche berücksichtigt und kompensiert werden kann.

Diese Aufgabe wird mit einer Anordnung der eingangs genannten Art gelöst, welche die im kennzeichnenden Teil des Patentanspruchs 1 angegebenen Merkmale aufweist.

Bevorzugte und vorteilhafte Ausgestaltungen der erfindungsgemäßen Anordnung gehen aus den Unteransprüchen hervor.

Die erfindungsgemäße Anordnung ist vorteilhaft bei Lasermodulen der optischen Nachrichtentechnik, insbesondere bidirektionalen Chips anwendbar.

Die Erfindung wird in der nachfolgenden Beschreibung anhand der Figuren beispielhaft näher erläutert. Es zeigen:
Figur 1 in perspektivischer Darstellung ein Ausführungsbeispiel einer erfindungsgemäßen Anordnung,
Figur 2 das Ausführungsbeispiel nach Figur 1 in Draufsicht von oben und
Figur 3 die in den Figuren 1 und 2 mit III bezeichnete Seite des Ausführungsbeispiels.

Die Figuren sind schematisch und nicht maßstäblich.

Bei dem dargestellten Ausführungsbeispiel ist auf der eine Ebene definierenden Oberfläche 10 eines Substrats 1 ein aus einer optischen Mantelschicht 24, einer laseraktiven Schicht 25 und einer otpischen Mantelschicht 26 bestehender Schichtenstapel aufgebracht, wobei die laseraktive Schicht 25 zwischen der unmittelbar auf der Oberfläche 10 aufgebrachten Mantelschicht 24 und der Mantelschicht 26 angeordnet ist. Die Schichten 24 bis 26 bestehen aus für Halbleiterlaser und Monitordetektoren üblichen Materialien, die aus dem Stand der Technik, beispielsweise dem oben angegebenen bekannt sind.

In diesen Schichtenstapel ist der Trenngraben 4 mit im wesentlichen senkrecht zur Oberfläche 10 stehenden und in einem Abstand d voneinander angeordneten Seitenwänden 23 und 32 geätzt, was den Vorteil hat, daß ein Standardätzverfahren wie beispielsweise reaktives Ionenätzen (RIE) angewendet werden kann und eine Verkippung des Wafers während der Ätzung (siehe obige Literaturstelle a)) mit speziellem Halter nicht erforderlich ist.

Der in den Figuren rechts vom Trenngraben 4 befindliche und von der Seitenwand 23 dieses Grabens 4 begrenzte Teil des Schichtenstapels ist für den Halbleiterlaser 2 und der links von diesem Trenngraben 4 befindliche und von der Seitenwand 32 dieses Grabens 4 begrenzte Teil dieses Stapels für den Monitordetektor 3 vorgesehen. Der die Laserstrahlung erzeugende aktive Bereich des Halbleiterlasers 2 befindet sich unter einer auf oder über der Oberfläche der Mantelschicht 25 aufgebrachten streifenförmigen Kontaktelektrode 2₁ und der die optoelektrische Wandlung ausführende aktive Bereich des Monitordetektors 3 unter der ebenfalls auf der vom Substrat 1 abgekehrten Oberfläche der Mantelschicht 25 aufgebrachten streifenförmigen Kontaktelektrode 3₁.

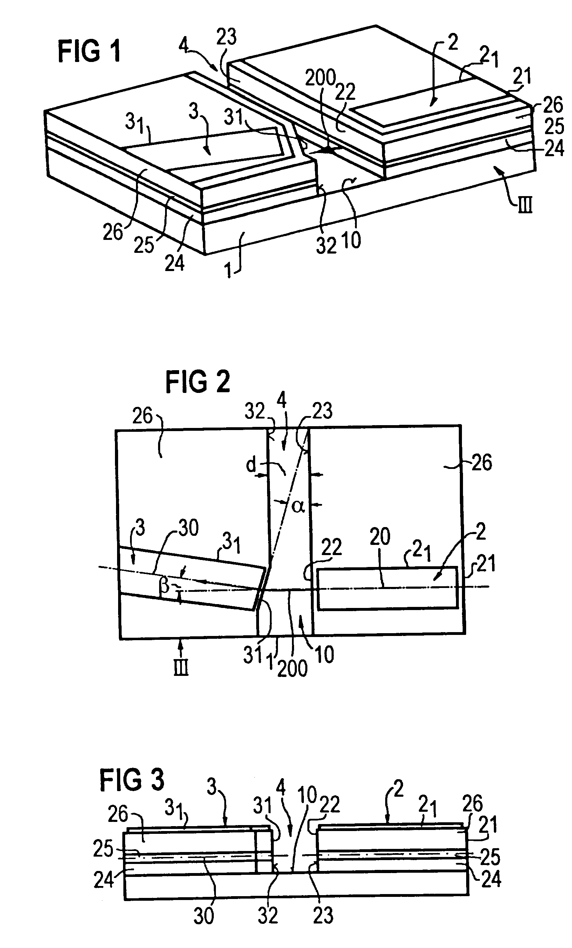

Die im Halbleiterlaser 2 angeregte Laserstrahlung breitet sich längs einer zur Ebene der Oberfläche 10 des Substrats 1 parallelen optischen Achse 20 dieses Halbleiterlasers 2 aus. In der Figur 2 kann beispielsweise die Zeichenebene als diese Ebene angesehen werden.

Die Nutzstrahlung des Halbleiterlasers 2 tritt aus einer zu dessen optischen Achse 20 im wesentlichen senkrecht stehenden Stirnfläche 21 dieses Lasers 2 aus, die vom Trenngraben 4 und Monitordetektor 3 abgekehrt ist.

Eine dem Trenngraben 4 und Monitordetektor 3 zugekehrte und ebenfalls senkrecht zur optischen Achse 20 des Halbleiterlasers 2 stehende Stirnfläche 22 dieses Lasers 2 ist durch den unterhalb der Kontaktelektrode 2₁ befindlichen Bereich der den Halbleiterlaser 2 begrenzenden Seitenwand 23 des Trenngrabens 4 definiert. Aus dieser Stirnfläche 22 tritt die dem Monitordetektor 3 zugeführte Laserstrahlung aus dem Halbleiterlaser 2 aus.

Eine dem Trenngraben 4 und Halbleiterlaser 2 zugekehrte Stirnfläche 31 des Monitordetektors 3 ist durch den unterhalb der Kontaktelektrode 3₁ befindlichen Bereich der den Monitordetektor 3 begrenzenden Seitenwand 32 des Trenngrabens 4 definiert. Dieser Stirnfläche 31 ist die aus der Stirnfläche 22 des Halbleiterlasers 2 divergent austretende Laserstrahlung zugeführt.

Die einander zugekehrten Stirnflächen 22 bzw. 31 des Halbleiterlasers 2 und des Monitordetektors 3 stehen erfindungsgemäß und im Unterschied zum Stand der Technik beide senkrecht zur Ebene der Oberfläche 10 des Substrats 1 aber schräg in einem parallel zu dieser Ebene gemessenen Winkel α zueinander. Durch diese Maßnahme ist es möglich, die Lichtbrechung an der Stirnfläche 31 des Monitordetektors 3 beim Eintritt der Laserstrahlung in den Detektor 3 zu berücksichtigen und zu kompensieren.

Dabei ist es zweckmäßig, wenn die optische Achse 20 des Halbleiterlasers 2 und eine zur Ebene der Oberfläche 10 des Substrats 1 parallele optische Achse 30 des Monitordetektors 3, längs der sich die in den Detektor 3 über dessen Stirnfläche 31 eingekoppelte Laserstrahlung ausbreitet, nicht koaxial oder parallel, sondern schräg in einem Winkel β zueinander angeordnet sind.

Vorzugsweise ist es so eingerichtet, daß die dem Monitordetektor 3 zugekehrte Stirnfläche 22 des Halbleiterlasers 2, senkrecht zu dessen optischer Achse 20 steht und die Stirnfläche 31 des Monitordetektors 3 derart schräg im Winkel α zu dieser Stirnfläche 22 des Halbleiterlasers 2 angeordnet ist, daß sich ein längs der optischen Achse 20 des Halbleiterlasers 2 ausbreitender Achsstrahl 200 der aus dieser Stirnfläche 22 des Halbleiterlasers 2 austretenden Laserstrahlung nach Brechung an der Stirnfläche 31 des Monitordetektors 3 im Monitordetektor 3 längs einer optischen Achse 30 dieses Detektors 3 ausbreitet.

Der Halbleiterlaser 2 und/oder Monitordetektor 3 kann bei der erfindungsgemäßen Anordnung eine Struktur sein, bei welcher der aktive Bereich des Lasers oder Detektors an unmittelbar dessen Stirnfläche 22 bzw. 31 grenzt oder durch einen passiven optischen Wellenleiter mit dieser Stirnfläche 22 bzw. 31 verbunden ist.

## Patentansprüche

1. Integriert-optische Anordnung, bestehend aus einem Halbleiterlaser (2) und einem optischen Monitordetektor (3), die auf der Oberfläche (10) eines gemeinsamen Substrats (1) derart integriert sind, daß eine Laserstrahlung emittierende Stirnfläche (22) des Halbleiterlasers (2) und eine zum Empfang dieser Laserstrahlung dienende Stirnfläche (31) des Monitordetektors (3) einander gegenüberliegen und in einem Abstand (d) voneinander und schräg in einem Winkel (α) zueinander angeordnet sind,
**dadurch gekennzeichnet**,
daß die einander gegenüberliegenden und schräg im Winkel (α) zueinander angeordneten Stirnflächen (22, 31) des Halbleiterlasers (2) und des Monitordetektors (3) beide im wesentlichen senkrecht zur Oberfläche (10) des Substrats (1) stehen.

2. Anordnung nach Anspruch 1,
**dadurch gekennzeichnet**,
daß eine zur Ebene der Oberfläche (10) des Substrats (1) parallele optische Achse (20) des Halbleiterlasers (2), längs der sich die im Halbleiterlaser (2) erzeugte Laserstrahlung ausbreitet, und eine zur Ebene der Oberfläche (10) des Substrats (1) parallele optische Achse (30) des Monitordetektors (3), längs der sich die in den Detektor (3) über dessen Stirnfläche (31) eingekoppelte Laserstrahlung ausbreitet, schräg in einem Winkel (β) zueinander angeordnet sind.

3. Anordnung nach Anspruch 2,
**dadurch gekennzeichnet**,
daß die Stirnfläche (22) des Halbleiterlasers (2) senkrecht zur optischen Achse (20) des Halbleiterlasers (2) und die Stirnfläche (31) des Monitordetektors (3) derart schräg im Winkel (α) zur Stirnfläche (22) des Halbleiterlasers (2) angeordnet ist, daß sich ein längs der optischen Achse (20) des Halbleiterlasers (2) ausbreitender Achsstrahl (200) der aus der Stirnfläche (22) des Halbleiterlasers (2) austretenden Laserstrahlung nach Brechung an der Stirnfläche (31) des Monitordetektors (3) im Monitordetektor (3) längs der optischen Achse (30) dieses Detektors (3) ausbreitet.
